(19) Europäisches Patentamt / European Patent Office / Office européen des brevets

(11) **EP 3 860 318 A1**

(12) **EUROPEAN PATENT APPLICATION**
published in accordance with Art. 153(4) EPC

(43) Date of publication:
04.08.2021 Bulletin 2021/31

(21) Application number: 19867774.2

(22) Date of filing: 20.09.2019

(51) Int Cl.:
*H05K 3/28* (2006.01)     *C09D 7/65* (2018.01)
*C09D 153/00* (2006.01)     *C09D 191/00* (2006.01)
*C09D 191/06* (2006.01)     *C09D 201/00* (2006.01)

(86) International application number:
PCT/JP2019/036937

(87) International publication number:
WO 2020/066882 (02.04.2020 Gazette 2020/14)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 25.09.2018 JP 2018178974
03.07.2019 JP 2019124658

(71) Applicant: Sekisui Fuller Company, Ltd.
Tokyo 108-0075 (JP)

(72) Inventors:
• NISHIDA, Haruhiko
  Hamamatsu-shi, Shizuoka 430-0834 (JP)
• NAGATA, Yoshiki
  Hamamatsu-shi, Shizuoka 430-0834 (JP)
• YOSHIMURA, Keiji
  Hamamatsu-shi, Shizuoka 430-0834 (JP)

(74) Representative: Müller-Boré & Partner
Patentanwälte PartG mbB
Friedenheimer Brücke 21
80639 München (DE)

(54) **HOT MELT COATING AGENT FOR COMPONENT-MOUNTED ELECTRONIC CIRCUIT BOARD**

(57)     The present invention provides a hot-melt coating agent that is excellent in bubble-suppression properties during coating, that is cured in a short period of time after coating, and that is excellent in tack-free properties and bleed-out resistance properties. The present invention provides a hot-melt coating agent for a component-mounted electronic circuit board that contains a thermoplastic resin (A) and a liquid softener (B); and that has a melt viscosity at 160°C ($\eta1$) of 20000 mPa·s or less and a melt viscosity at 180°C ($\eta2$) of 10000 mPa·s or less, wherein the ratio of the melt viscosity at 160°C ($\eta1$) to the melt viscosity at 180°C ($\eta2$) ($\eta1/\eta2$) is 1.0 to 5.0.

**Description**

Technical Field

The present invention relates to a hot-melt coating agent for component-mounted electronic circuit boards.

Background Art

Component-mounted electronic circuit boards are conventionally coated with a coating agent for insulation and moisture-proofing for the purpose of protecting the metal-exposed parts of electronic components such as IC chips and coiled chips from moisture, dust, corrosive gas, etc. The IC chips are also referred to as "IC packages."

With the increasing density of mounted electronic components, electronic circuit boards have been highly integrated. Coating agents are a key factor in ensuring the reliability of electronic circuit boards on which such electronic components are mounted. Major coating agents applied to component-mounted electronic circuit boards include moisture-curable coating agents, UV-curable coating agents, and solvent-drying coating agents.

A coating material that contains a polyolefin resin as a base material and 10 to 35 wt% of a softener is suggested as a coating agent for electronic circuit boards (e.g., PTL 1).

Citation List

Patent Literature

PTL 1: JP2005-194392

Summary of Invention

Technical Problem

Moisture-curable coating agents contain silicone resin, and the curing time thereof depends on humidity. Thus, in some cases, it may take several hours until such agents are cured and become tack-free; this affects the productivity of components.

UV-curable coating agents in use include coating agents that contain an acrylic-based compound, such as urethane acrylate and a (meth)acrylate monomer. In some electronic components, some parts of the components are not exposed to UV, and these parts may not be cured. Thus, it can be hard to cure an applied UV-curable coating agent.

Solvent-drying coating agents in use contain a solvent such as ethyl cyclohexane or methyl cyclohexane. The solvent must be evaporated by performing a drying step, and time is required until these agents become tack-free; it may take more than one hour for drying at room temperature.

The coating material disclosed in PTL 1 does not require a long time for curing, due to the use of a polyolefin resin as a base material. However, the solidified coating surface tends to remain tacky due to the nature of the resin. Additionally, liquid paraffin used as a softener may bleed out.

Bubbles may also form when a coating agent is applied to an electronic circuit board to form a coating. Typically, when a coating agent is applied onto an electronic circuit board on which an electronic component such as an IC chip is mounted, air is pushed out of the pitch gap between leads of the IC chip during coating, and comes out in the form of bubbles; this causes a decrease in insulation properties. Because PTL 1 does not consider the reduction of bubbles during coating, the coating agent thereof would not provide insulation properties as a coating agent for circuit boards.

The present invention was made in view of the problems described above. An object of the invention is to provide a hot-melt coating agent that is excellent in bubble-suppression properties during coating, that is cured in a short period of time after coating, and that is excellent in tack-free properties and bleed-out resistance properties.

Solution to Problem

The present inventors conducted extensive research to achieve the object. They found that the object can be achieved by a hot-melt coating agent for component-mounted electronic circuit boards that contains a thermoplastic resin (A) and a liquid softener (B); and that has a melt viscosity at 160°C ($\eta$1) of 20000 mPa·s or less and a melt viscosity at 180°C ($\eta$2) of 10000 mPa·s or less, wherein the ratio of the melt viscosity at 160°C ($\eta$1) to the melt viscosity at 180°C ($\eta$2) ($\eta$1/$\eta$2) is 1.0 to 5.0. The inventors then completed the present invention.

Specifically, the present invention relates to the following hot-melt coating agents for component-mounted electronic circuit boards.

Item 1. A hot-melt coating agent for a component-mounted electronic circuit board comprising
a thermoplastic resin (A), and
a liquid softener (B),
the hot-melt coating agent having a melt viscosity at 160°C ($\eta$1) of 20000 mPa·s or less and a melt viscosity at 180°C ($\eta$2) of 10000 mPa·s or less, wherein the ratio of the melt viscosity at 160°C ($\eta$1) to the melt viscosity at 180°C ($\eta$2), which is $\eta$1/$\eta$2, is 1.0 to 5.0.

Item 2. The hot-melt coating agent for a component-mounted electronic circuit board according to Item 1, wherein within the temperature range of 50°C or more in viscoelasticity measurement performed within the temperature range of -40°C to 130°C, the temperature at the point of intersection of a temperature-storage modulus G' curve with a temperature-loss modulus G" curve is 80°C or more.

Item 3. The hot-melt coating agent for a component-mounted electronic circuit board according to Item 1 or 2, wherein the thermoplastic resin (A) contains at least one member selected from the group consisting of olefin-based block copolymers (OBC), styrene-butylene-styrene copolymers (SBS), styrene-isoprene-styrene copolymers (SIS), styrene-ethylene/butylene-styrene copolymers (SEBS), styrene-ethylene/propylene-styrene copolymers (SEPS), and styrene-ethylene/ethylene/propylene-styrene copolymers (SEEPS).

Item 4. The hot-melt coating agent for a component-mounted electronic circuit board according to any one of Items 1 to 3, wherein the liquid softener (B) is at least one member selected from the group consisting of paraffin-based process oils, naphthene-based process oils, and synthetic hydrocarbon-based oils.

Item 5. The hot-melt coating agent for a component-mounted electronic circuit board according to any one of Items 1 to 4, wherein the content of the liquid softener (B) is 100 to 500 parts by mass per 100 parts by mass of the thermoplastic resin (A) .

Item 6. The hot-melt coating agent for a component-mounted electronic circuit board according to any one of Items 1 to 5, further comprising at least one wax (C) selected from the group consisting of paraffin-based wax, vinyl acetate-based wax, polyethylene-based wax, polypropylene-based wax, and Fischer-Tropsch wax, wherein the content of the wax (C) is 50 parts by mass or less per 100 parts by mass of the thermoplastic resin (A) .

Item 7. The hot-melt coating agent for a component-mounted electronic circuit board according to any one of Items 1 to 6, further comprising at least one tackifier (D) selected from the group consisting of naturally occurring tackifiers, petroleum resin-based tackifiers, and hydrogenated products of petroleum resin-based tackifiers, wherein the content of the tackifier (D) is 150 parts by mass or less per 100 parts by mass of the thermoplastic resin (A).

Advantageous Effects of Invention

The hot-melt coating agent for a component-mounted electronic circuit board according to the present invention is excellent in bubble-suppression properties during coating, is cured in a short period of time after coating, and is excellent in tack-free properties and bleed-out resistance properties.

Description of Embodiments

The hot-melt coating agent for a component-mounted electronic circuit board according to the present invention (simply "hot-melt coating agent" below) contains a thermoplastic resin (A) and a liquid softener (B); and the hot-melt coating agent has a melt viscosity at 160°C ($\eta$1) of 20000 mPa·s or less and a melt viscosity at 180°C ($\eta$2) of 10000 mPa·s or less, wherein the ratio of the melt viscosity at 160°C ($\eta$1) to the melt viscosity at 180°C ($\eta$2) ($\eta$1/$\eta$2) is 1.0 to 5.0. Due to this configuration, the hot-melt coating agent according to the present invention is excellent in bubble-suppression properties during coating, is cured in a short period of time after coating, and is excellent in tack-free properties and bleed-out resistance properties. Thus, coating with the hot-melt coating agent can be performed with a dispenser. Due to its excellent bubble-suppression properties, the hot-melt coating agent can suppress deterioration of the insulation properties of an electronic component on a substrate. Because the hot-melt coating agent is solidified and becomes tack-free in a short period of time after coating, the efficiency of the process can be improved, and the hot-melt coating agent can have excellent bleed-out resistance properties.
The hot-melt coating agent according to the present invention is described in detail below.

Thermoplastic Resin (A)

The thermoplastic resin (A) can be any thermoplastic resin; and thermoplastic resins for use include polystyrene based-resins, polyolefin based-resins, polyester based-resins, and polyurethane-based resins. Of these, from the standpoint of further increased electrical insulation and moisture resistance, polystyrene based-resins and polyolefin based-resins are preferable, and polystyrene based-resins are more preferable.

The thermoplastic resins may be used singly, or in a combination of two or more.

Polystyrene based-resins include homopolymers or copolymers of styrene-based monomers, such as styrene, α-methylstyrene, and chlorostyrene; and styrene-based block copolymers, such as block copolymers of a styrene-based monomer with an olefin-based monomer, such as an ethylene monomer, a propylene monomer, and a butylene monomer.

Examples of styrene-based block copolymers include styrene-based thermoplastic elastomers; more specifically, styrene-butylene-styrene copolymers (SBS) and styrene-isoprene-styrene copolymers (SIS).

Alternatively, hydrogenated products of styrene-based block copolymers may also be usable. Hydrogenated products of styrene-based block copolymers include block copolymers obtained by subjecting a vinyl-based aromatic hydrocarbon and a conjugated diene compound to block copolymerization, and hydrogenating all or some of the blocks derived from the conjugated diene compound in the obtained block copolymer. Specifically, hydrogenated products of styrene-based block copolymers include styrene-ethylene/butylene-styrene copolymers (SEBS), styrene-ethylene/propylene-styrene copolymers (SEPS), styrene-ethylene/ethylene/propylene-styrene copolymers (SEEPS), styrene-ethylene/butylene/styrene-styrene copolymers (SEBSS), and styrene-ethylene/propylene/styrene-styrene copolymers (SEPSS). Of these, from the standpoint of further increasing the bleed-out resistance properties of the hot-melt coating agent, styrene-butylene-styrene copolymers (SBS), styrene-isoprene-styrene copolymers (SIS), styrene-ethylene/butylene-styrene copolymers (SEBS), styrene-ethylene/propylene-styrene copolymers (SEPS), and styrene-ethylene/ethylene/propylene-styrene copolymers (SEEPS) are preferable; and styrene-ethylene/butylene-styrene copolymers (SEBS), styrene-ethylene/propylene-styrene copolymers (SEPS), and styrene-ethylene/ethylene/propylene-styrene copolymers (SEEPS) are more preferable.

The copolymers such as styrene-ethylene/butylene-styrene copolymers (SEBS), styrene-ethylene/propylene-styrene copolymers (SEPS), and styrene-ethylene/ethylene/propylene-styrene copolymers (SEEPS) for use are preferably those whose main structure is a triblock structure. The triblock structure refers to a styrene-based block copolymer in which the styrene unit at the ends is an end block phase in its structure; and the ethylene/butylene unit, the ethylene/propylene unit, and the ethylene/ethylene/propylene unit are respectively a mid-block phase in the copolymers described above. The triblock structure are also referred to as an A-B-A form. The use of these styrene-based block copolymers whose main structure is a triblock structure further improves the adhesion between the coating formed from the hot-melt coating agent according to the present invention and a component-mounted electronic circuit board when the hot-melt coating agent according to the present invention contains a tackifier (D), described later.

The styrene-based block copolymer preferably has a weight average molecular weight (Mw) of 20000 to 200000. A styrene-based block copolymer having a weight average molecular weight (Mw) within this range further improves bubble-suppression properties during coating.

In the present specification, the weight average molecular weight (Mw) of a styrene-based block copolymer refers to a measurement value determined based on polystyrene standards by using a gel permeation chromatography measurement device.

The weight average molecular weight (Mw) of the styrene-based block copolymers described above can be measured, for example, by using the following measurement device under the following measurement conditions.

Measurement Device: ACQUITY APC (tradename), produced by Waters Corporation
Measurement Condition: Column

- ACQUITY APC XT45 1.7 μm × 1 column
- ACQUITY APC XT125 2.5 μm × 1 column
- ACQUITY APC XT450 2.5 μm × 1 column

Mobile Phase: Tetrahydrofuran 0.8 mL/minute
Sample Concentration: 0.2 mass%
Detector: Differential refractive index (RI) detector
Standard Substance: Polystyrene (produced by Waters Corporation; molecular weight: 266 to 1,800,000)
Column Temperature: 40°C
RI Detector Temperature: 40°C

The styrene-based block copolymer for use may be a commercially available product. Examples of commercially available products include G1650 (trade name, produced by Kraton Corporation) as a styrene-ethylene/butylene-styrene copolymer (SEBS); Septon 2004 (trade name, produced by Kuraray Co., Ltd.) as a styrene-ethylene/propylene-styrene copolymer (SEPS); and Septon 4033 (trade name, produced by Kuraray Co., Ltd.) as a styrene-ethylene/ethylene/propylene-styrene copolymer (SEEPS).

The styrene-based block copolymers may be used singly, or in a combination of two or more.

The styrene content in a styrene-based block copolymer is preferably 10 mass% or more, and more preferably 20 mass% or more, based on the styrene-based block copolymer taken as 100 mass%. A lower limit of the styrene content in a styrene-based block copolymer within these ranges leads to a further shortened curing time after coating of the hot-melt coating agent according to the present invention, and further increased tack-free properties. The styrene content in a styrene-based block copolymer is also preferably 50 mass% or less, and more preferably 40 mass% or less, based on the styrene-based block copolymer taken as 100 mass%. An upper limit of the styrene content in a styrene-based block copolymer within these ranges leads to further improved adhesion between the coating formed from the hot-melt coating agent according to the present invention and a component-mounted electronic circuit board.

In the present specification, the "styrene content" in a styrene-based block copolymer refers to the content (mass%) of styrene blocks in a styrene-based block copolymer.

The styrene content in a styrene-based block copolymer in the present specification can be calculated, for example, by a method using proton nuclear magnetic resonance or IR spectroscopy, in accordance with JIS K6239.

The polyolefin based-resin can be any polyolefin based-resin. Examples include olefin-based copolymers such as polyethylene, polypropylene, polybutene, polymethyl pentene, ethylene-propylene copolymers, ethylene-octene copolymers, and ethylene-butene copolymers; and olefin-based block copolymers that are block copolymers of these resins. Of these, an olefin-based block copolymer is preferably used.

The polyolefin based-resin for use may be a commercially available product. Examples of commercially available products of polyolefin based-resins include Infuse D9807 (trade name, produced by The Dow Chemical Company) as an olefin block copolymer (OBC).

The content of the thermoplastic resin (A) in the hot-melt coating agent according to the present invention is preferably 15 mass% or more, and more preferably 19 mass% or more, based on the hot-melt coating agent taken as 100 mass%. A lower limit of the content of the thermoplastic resin (A) in the hot-melt coating agent within these ranges leads to a further shortened period of time for curing after coating of the hot-melt coating agent according to the present invention, and further increased tack-free properties. The content of the thermoplastic resin (A) in the hot-melt coating agent according to the present invention is preferably 34 mass% or less, and more preferably 25 mass% or less, based on the hot-melt coating agent taken as 100 mass%. An upper limit of the content of the thermoplastic resin (A) in the hot-melt coating agent within these ranges leads to further improved adhesion between the coating formed from the hot-melt coating agent according to the present invention and a component-mounted electronic circuit board.

Liquid Softener (B)

The hot-melt coating agent according to the present invention contains a liquid softener (B). In the present specification, "liquid" refers to the state of matter that shows fluidity at room temperature (5 to 35°C).

The liquid softener (B) can be any liquid softener. Examples include paraffin-based process oils, naphthene-based process oils, aromatic process oils, liquid paraffin, and synthetic hydrocarbon-based oils. Of these, from the standpoint of further improved heating stability, paraffin-based process oils, naphthene-based process oils, liquid paraffin, and synthetic hydrocarbon-based oils are preferable; and paraffin-based process oils, naphthene-based process oils, and synthetic hydrocarbon-based oils are more preferable. From the standpoint of further improved coating applicability, paraffin-based process oils are still more preferable.

The paraffin-based process oil for use may be a commercially available product. Examples of commercially available products of paraffin-based process oils include PW-32 (produced by Idemitsu Kosan Co., Ltd.), Diana Fresia S32 (produced by Idemitsu Kosan Co., Ltd.), PS-32 (produced by Idemitsu Kosan Co., Ltd.), and PS-90 (produced by Idemitsu Kosan Co., Ltd.). The use of paraffin-based process oil suppresses an increase in melt viscosity of the hot-melt coating agent at low temperatures; and thus further decreases the ratio of the melt viscosity at 160°C ($\eta$1) to the melt viscosity at 180°C ($\eta$2) ($\eta$1/$\eta$2), thereby further improving bubble-suppression properties during coating.

The liquid softener (B) has a kinematic viscosity at 40°C of preferably 30 mm$^2$/S or more, more preferably 50 mm$^2$/S or more, still more preferably 70 mm$^2$/S or more, and particularly preferably 90 mm$^2$/S or more. A lower limit of the kinematic viscosity within these ranges prevents the temperature at the point of intersection of a temperature-storage modulus G' curve and a temperature-loss modulus G" curve of the hot-melt coating agent according to the present invention from becoming overly low, thereby further increasing high-temperature flow resistance. The temperature at the point of intersection of a temperature-storage modulus G' curve with a temperature-loss modulus G" curve is within the temperature range of 50°C or more in viscoelasticity measurement performed within the temperature range of -40°C to 130°C. The upper limit of the kinematic viscosity of paraffin-based process oil can be any value; and is preferably 450 $mm^2/S$ or less, more preferably 300 $mm^2/S$ or less, still more preferably 200 $mm^2/S$ or less, and particularly preferably 150 $mm^2/S$ or less.

In the present specification, the kinematic viscosity refers to a value measured by the measurement method with the viscometer described in JIS Z8803. For example, when the value of the viscosity of liquid measured with a single-cylinder rotational viscometer is $\eta$, the kinematic viscosity can be calculated from the following formula.

$$\text{Kinematic viscosity } (mm^2/S) = \eta(mPa\cdot s)/(\text{density of liquid}) \ (g/cm^2)$$

In the present specification, the density refers to a value measured by the method described in JIS Z8804.

In the present specification, high-temperature flow resistance refers to the following properties. A hot-melt coating agent exposed to high temperatures melts and starts flowing. The "flow" means that the hot-melt coating agent applied to a component-mounted electronic circuit board starts flowing from the board. Specifically, high-temperature flow resistance is an index of whether a hot-melt coating agent melts and flows at high temperatures (e.g., 80°C or more). Hot-melt coating agents typically have a softening point; in actuality, however, a hot-melt coating agent starts melting and flowing at a temperature within a range lower than the softening point. Thus, the softening point and high-temperature flow resistance must be distinguished from each other. If the component-mounted electronic circuit board for use reaches a temperature within a high temperature range, its high-temperature flow resistance must be higher than the environmental temperature. High-temperature flow resistance can be an index to determine whether a hot-melt coating agent is suitable for coating a component-mounted electronic circuit board.

The naphthene-based process oil for use may be a commercially available product. Examples of commercially available products of naphthene-based process oils include N-90 (produced by Idemitsu Kosan Co., Ltd.), Diana Fresia N28 (produced by Idemitsu Kosan Co., Ltd.), Diana Fresia U46 (produced by Idemitsu Kosan Co., Ltd.), and Diana Process Oil NR (produced by Idemitsu Kosan Co., Ltd.).

The liquid paraffin for use may be a commercially available product. Examples of commercially available products of liquid paraffin include P-100 (produced by MORESCO Corporation) and Kaydol (produced by Sonneborn LLC.).

The synthetic hydrocarbon-based oil for use may be a commercially available product. Example of commercially available products of synthetic hydrocarbon-based oils include Lucant HC-10 (produced by Mitsui Chemicals, Inc.) and Lucant HC-20 (produced by Mitsui Chemicals, Inc.).

The liquid softener (B) may be used singly, or in a combination of two or more.

The content of the liquid softener (B) in the hot-melt coating agent according to the present invention is preferably 100 parts by mass or more, more preferably 110 parts by mass or more, and still more preferably 120 parts by mass or more, per 100 parts by mass of the thermoplastic resin (A). A lower limit of the content of the liquid softener (B) within these ranges further improves the bubble-suppression properties of the hot-melt coating agent, and is more likely to further suppress the formation of bubbles on the leads of a mounted IC chip during coating. The content of the liquid softener (B) in the hot-melt coating agent according to the present invention is preferably 500 parts by mass or less, more preferably 450 parts by mass or less, still more preferably 400 parts by mass or less, particularly preferably 300 parts by mass or less, and most preferably 200 parts by mass or less, per 100 parts by mass of the thermoplastic resin (A). An upper limit of the content of the liquid softener (B) within these ranges further suppresses a decrease in melt viscosity of the hot-melt coating agent, and further improves bubble-suppression properties. An upper limit of the content of the liquid softener (B) in the hot-melt coating agent according to the present invention prevents the temperature at the point of intersection of a temperature-storage modulus G' curve with a temperature-loss modulus G" curve within the temperature range of 50°C or more in viscoelasticity measurement performed within the temperature range of -40°C to 130°C from becoming overly low; and further improves high-temperature flow resistance, thereby further suppressing the flow at high temperatures of the hot-melt coating agent applied to a component-mounted electronic circuit board. Additionally, an upper limit of the content of the liquid softener (B) within these ranges further suppresses an increase in dissipation factor, which is an electrical characteristic of the hot-melt coating agent, and thus makes the hot-melt coating agent more suitable for use in a component-mounted electronic circuit board.

Wax (C)

The hot-melt coating agent according to the present invention may contain wax (C). Adding wax (C) to the hot-melt coating agent can further decrease the ratio of the melt viscosity at 160°C ($\eta$1) to the melt viscosity at 180°C ($\eta$2) ($\eta$1/$\eta$2), further improves bubble-suppression properties during coating, and further improves tack-free properties.

The wax (C) can be any wax. Examples include mineral-based wax, such as paraffin-based wax and microcrystalline wax; polyolefin-based wax, such as polyethylene-based wax, polypropylene-based wax, and Fischer-Tropsch wax; and vinyl acetate-based wax, such as ethylene-vinyl-acetate-copolymer (EVA)-based wax. Of these, from the standpoint of further improving bubble-suppression properties, vinyl acetate-based wax, polyethylene-based wax, polypropylene-based wax, and Fischer-Tropsch wax are preferable; paraffin-based wax and Fischer-Tropsch wax are more preferable.

The wax (C) may be used singly, or in a combination of two or more.

The wax (C) for use may be commercially available product. Examples of commercially available products of paraffin-based wax include 64-66C (produced by PetroChina Company Limited), and examples of commercially available products of Fischer-Tropsch wax include SX105 (produced by Nippon Seiro Co., Ltd.).

The wax (C) has a melting point of preferably 60°C or more, and more preferably 90°C or more. A lower limit of the melting point of the wax (C) within these ranges prevents the temperature at the point of intersection of a temperature-storage modulus G' curve with a temperature-loss modulus G" curve of the hot-melt coating agent according to the present invention within the temperature range of 50°C or more in viscoelasticity measurement performed within the temperature range of -40°C to 130°C from becoming overly low; and further improves high-temperature flow resistance, thereby further suppressing the flow of the hot-melt coating agent applied to a component-mounted electronic circuit board at high temperatures. The upper limit of the melting point of the wax (C) is not particularly limited, and is about 115°C.

The content of the wax (C) in the hot-melt coating agent according to the present invention is preferably 60 parts by mass or less, more preferably 50 parts by mass or less, and still more preferably 40 parts by mass or less, per 100 parts by mass of the thermoplastic resin (A). An upper limit of the content of the wax (C) within these ranges makes it more unlikely for the hot-melt coating agent to become hard and brittle. The lower limit of the content of the wax (C) is not particularly limited; and is preferably 0 parts by mass or more, and more preferably 25 parts by mass or more. A lower limit of the content of the wax (C) within these ranges further improves bubble-suppression properties during coating, and further improves the insulation reliability of a component-mounted board.

Tackifier (D)

The hot-melt coating agent according to the present invention may contain a tackifier (D). Adding a tackifier (D) further improves the adhesion between the coating formed from the hot-melt coating agent according to the present invention and a component-mounted electronic circuit board.

The tackifier for preferable use includes a naturally occurring tackifier, a petroleum resin-based tackifier, and a hydrogenated product of a petroleum resin-based tackifier.

Naturally occurring tackifiers include rosin-based tackifiers and terpene-based tackifiers.

Rosin-based tackifiers include unmodified rosin, such as tall oil rosin, gum rosin, and wood rosin; polymerized rosin; disproportionated rosin; hydrogenated rosin; maleic acid-modified rosin; and fumaric acid-modified rosin. Esterified rosin-based tackifiers obtained by esterifying these rosin-based tackifiers can also be used. Specific examples include rosin-based tackifiers such as glycerol ester, pentaerythritol ester, methyl ester, methyl ester, ethyl ester, butyl ester, and ethylene glycol ester.

Terpene-based tackifiers include terpene resins, such as $\alpha$-pinene polymers, $\beta$-pinene polymers, and dipentene polymers; and modified terpene resins, such as terpene phenol resin, styrene-modified terpene resin, and hydrogenated terpene resin.

Petroleum resin-based tackifiers include petroleum resins, such as C5-based petroleum resin, C9-based petroleum resin, C5C9-based petroleum resin, and dicyclopentadiene-based petroleum resin. Petroleum resin-based tackifiers also include hydrogenated petroleum resins obtained by hydrogenating these petroleum resins. Specific examples include hydrogenated C5-based resin, hydrogenated C9-based resin, hydrogenated dicyclopentadiene-based resin, and hydrogenated C5C9-based resin.

C5-based petroleum resin refers to a petroleum resin whose starting material is the C5 fractions of petroleum. C9-based petroleum resin refers to a petroleum resin whose starting material is the C9 fractions of petroleum. C5C9-based petroleum resin refers to a petroleum resin whose starting material is the C5 fractions and C9 fractions of petroleum. C5 fractions include cyclopentadiene, isoprene, and pentane. C9 fractions include styrene, vinyl toluene, and indene. The C5-based petroleum resin and C5C9-based petroleum resin for preferable use may be one that contains dicyclopentadiene (DCPD) derived from cyclopentadiene, which is one type of C5 fraction, in its skeleton.

The tackifier (D) is preferably a petroleum resin-based tackifier or a hydrogenated petroleum resin that is a hydrogenated product of a petroleum resin-based tackifier, from the standpoint of further improving the tack-free properties of the hot-melt coating agent according to the present invention. The tackifier (D) is preferably a terpene-based tackifier or a hydrogenated product thereof, from the standpoint of further improving the adhesion between the coating formed from the hot-melt coating agent according to the present invention and a component-mounted electronic circuit board.

The tackifier (D) may be used singly, or in a combination of two or more.

The tackifier (D) for use may be a commercially available product. Examples of commercially available products of terpene-based tackifiers include YS Resin TO-125 (a terpene resin produced by Yasuhara Chemical Co., Ltd.).

Examples of modified terpene resins that are terpene-based tackifiers include YS Polyster (a terpene phenol resin produced by Yasuhara Chemical Co., Ltd.) and Sylvares 1150 (produced by Arizona Chemical). Examples of hydrogenated petroleum resins that are petroleum resin-based tackifiers include I-MARV P-145 (produced by Idemitsu Kosan Co., Ltd.).

The content of the tackifier (D) in the hot-melt coating agent according to the present invention is preferably 180 parts by mass or less, more preferably 150 parts by mass or less, and still more preferably 130 parts by mass or less, per 100 parts by mass of the thermoplastic resin (A). An upper limit of the content of the tackifier (D) within these ranges further improves the tack-free properties of the hot-melt coating agent. The lower limit of the content of the tackifier (D) is not particularly limited; and may be 0 parts by mass, or 90 parts by mass.

Solid Softener (E)

The hot-melt coating agent according to the present invention may contain a solid softener (E). Adding a solid softener (E) to the hot-melt coating agent further improves the high-temperature flow resistance of a coating formed from the hot-melt coating agent according to the present invention.

The solid softener (E) can be any solid softener. Examples include triethylene glycol tribenzoate, trimethylol ethane tribenzoate, glycerol tribenzoate, sucrose benzoate, pentaerythritol tetrabenzoate, 2,2-dimethyl-1,3-propanediol dibenzoate, triethylene glycol dibenzoate, glycerol tribenzoate, 2-hydroxymethyl-2-methyl-1,3-propanediol tribenzoate pentaerythritol tetrabenzoate, and neopentylglycol dibenzoate.

The solid softener (E) is preferably a solid softener that recrystallizes in a hot-melt coating agent. Examples of such solid softeners include benzoic acid ester-based plasticizers that are solid at room temperature, such as cyclohexane dimethanol dibenzoate. The solid softener (E) is preferably a solid at ambient temperature, and has a softening point of more than 60°C. Such solid softeners include 1,4-cyclohexane dimethanol dibenzoate (including *cis-* and trans-isomers).

The solid softener (E) for use may be a commercially available product. Examples of commercially available products of cyclohexane dimethanol dibenzoate include Benzoflex 352 (produced by Eastman Chemical Company).

The solid softener (E) may be used singly, or in a combination of two or more.

The content of the solid softener (E) in the hot-melt coating agent according to the present invention is preferably 60 parts by mass or less, and more preferably 30 parts by mass or less, per 100 parts by mass of the thermoplastic resin (A). An upper limit of the content of the solid softener (E) within these ranges further improves the high-temperature flow resistance of the hot-melt coating agent. The lower limit of the content of the solid softener (E) is not particularly limited; and may be 0 parts by mass, or 20 parts by mass.

Antioxidant (F)

The hot-melt coating agent according to the present invention may contain an antioxidant (F).

Examples of antioxidants include hindered phenol-based antioxidants, such as 2,6-di-t-butyl-4-methylphenol, n-octadecyl-3-(4'-hydroxy-3',5'-di-t-butylphenyl)propionate, 2,2'-methylene bis(4-methyl-6-t-butylphenol), 2,2'-methylene bis(4-ethyl-6-t-butylphenol), 2,4-bis(octylthiomethyl)-o-cresol, 2-t-butyl-6-(3-t-butyl-2-hydroxy-5-methylbenzyl)-4-methylphenyl acrylate, 2,4-di-t-amyl-6-[1-(3,5-di-t-amyl-2-hydroxyphenyl)ethyl]phenyl acrylate, 2-[1-(2-hydroxy-3,5-di-tert-pentylphenyl)]acrylate, and tetrakis [methylene-3-(3,5-di-t-butyl-4-hydroxyphenyl)propionate]methane; sulfur-based antioxidants, such as dilauryl thiodipropionate, lauryl stearyl thiodipropionate, and pentaerythritol tetrakis(3-laurylthiopropionate); and phosphorus-based antioxidants, such as tris(nonylphenyl) phosphite and tris(2,4-di-t-butylphenyl) phosphite.

The antioxidant (F) may be used singly, or in a combination of two or more.

The content of the antioxidant (F) in the hot-melt coating agent according to the present invention is preferably 2 parts by mass or less, and more preferably 1.0 parts by mass or less, per 100 parts by mass of the thermoplastic resin (A). The lower limit of the content of the antioxidant (F) is not particularly limited; and may be 0 parts by mass, or 0.5 parts by mass.

Other Additives

The hot-melt coating agent according to the present invention may contain other additives to the extent that they do not essentially interfere with the object of the present invention. Examples of other additives include color pigments and flame retardants.

Color pigments include inorganic pigments, such as titanium oxide.

Flame retardants include inorganic flame retardants, such as phosphate-ester-based flame retardants, melanin-based flame retardants, and magnesium hydroxide.

The total content of other additives in the hot-melt coating agent according to the present invention is preferably 0.1 parts by mass or more, and more preferably 0.5 parts by mass or more, per 100 parts by mass of the thermoplastic resin (A). The total content of other additives is preferably 40 parts by mass or less, and more preferably 30 parts by mass or less, per 100 parts by mass of the thermoplastic resin (A). A total content of other additives within these ranges leads to further improved bubble-suppression properties of the hot-melt coating agent according to the present invention during coating, further shortened curing time after coating, and further improved tack-free properties and bleed-out resistance properties; while imparting desired physical properties to the hot-melt coating agent according to the present invention.

The hot-melt coating agent according to the present invention has a melt viscosity at 160°C ($\eta 1$) of 20000 mPa·s or less. A $\eta 1$ exceeding 20000 mPa·s leads to the hot-melt coating agent according to the present invention having a viscosity unsuitable for coating with a dispenser and a failure to suppress the formation of bubbles on the leads of an IC chip, resulting in a failure to obtain an excellent coating film; thus, a $\eta 1$ exceeding 20000 mPa·s decreases the reliability of the electronic component and the bubble-suppression properties of the hot-melt coating agent. The melt viscosity at 160°C ($\eta 1$) of the hot-melt coating agent is preferably 16000 mPa·s or less, and more preferably 15000 mPa·s or less. The melt viscosity at 160°C ($\eta 1$) of the hot-melt coating agent is also preferably 1000 mPa·s or more, and more preferably 6000 mPa·s or more.

The hot-melt coating agent according to the present invention has a melt viscosity at 180°C ($\eta 2$) of 10000 mPa·s or less. A $\eta 2$ exceeding 10000 mPa·s leads to the hot-melt coating agent according to the present invention having a viscosity unsuitable for coating with a dispenser and a failure to suppress the formation of bubbles on the leads of an IC chip, resulting in a failure to obtain an excellent coating film; thus, a $\eta 2$ exceeding 10000 mPa·s decreases the reliability of the electronic component and the bubble-suppression properties of the hot-melt coating agent. The melt viscosity at 180°C ($\eta 2$) of the hot-melt coating agent is preferably 6000 mPa·s or less, and more preferably 4000 mPa·s or less. The melt viscosity at 180°C ($\eta 2$) of the hot-melt coating agent is also preferably 500 mPa·s or more, and more preferably 2000 mPa·s or more.

In the present specification, "melt viscosity" refers to the viscosity of the hot-melt coating agent that has been heated and melted at a predetermined temperature. The melt viscosity at 160°C ($\eta 1$) and the melt viscosity at 180°C ($\eta 2$) each refer to the value determined by heating and melting a hot-melt coating agent, and measuring the viscosity of the agent at 160°C and 180°C with a Brookfield RVT viscometer (spindle No. 27).

The hot-melt coating agent according to the present invention has a ratio of the melt viscosity at 160°C ($\eta 1$) to the melt viscosity at 180°C ($\eta 2$) ($\eta 1/\eta 2$) of 1.0 to 5.0. A ratio $\eta 1/\eta 2$ exceeding 5.0 decreases the bubble-suppression properties of the hot-melt coating agent according to the present invention during coating. The ratio $\eta 1/\eta 2$ is preferably 4.5 or less, more preferably 4.0 or less, still more preferably 3.5 or less, and particularly preferably 3.0 or less. The ratio $\eta 1/\eta 2$ is preferably 1.5 or more, and more preferably 2.0 or more.

In the present specification, the ratio of the melt viscosity at 160°C ($\eta 1$) to the melt viscosity at 180°C ($\eta 2$) ($\eta 1/\eta 2$) refers to a value as measured by the following measurement method. Specifically, a hot-melt coating agent is heated and melted, and the viscosity of the melted hot-melt coating agent is measured at 160°C and 180°C with a Brookfield RVT viscometer (spindle No. 27). The viscosity at 160°C and the viscosity at 180°C are respectively determined to be $\eta 1$ and $\eta 2$. Based on the measurement results, the ratio of the melt viscosity at 160°C to the melt viscosity at 180°C ($\eta 1/\eta 2$) is calculated.

The hot-melt coating agent according to the present invention has a temperature at the point of intersection of a temperature-storage modulus G' curve with a temperature-loss modulus G" curve (simply "the point of intersection" below) of preferably 80°C or more, and more preferably 90°C or more, within the temperature range of 50°C or more in viscoelasticity measurement performed within the temperature range of -40°C to 130°C. A lower limit of the temperature at the point of intersection within these ranges further improves the high-temperature flow resistance, and makes the hot-melt coating agent more suitable for use in a component-mounted electronic circuit board. The upper limit of the temperature at the point of intersection is not particularly limited, and is preferably 130°C or less, and more preferably 120°C or less.

The temperature at the point of intersection can be measured by the following method. Specifically, a hot-melt coating agent is melted by heating at 180°C, and dropped on a release-treated PET film. Subsequently, another release-treated PET film is prepared and placed on the hot-melt coating agent such that the release-treated surface of the film comes into contact with the hot-melt coating agent, followed by pressing the PET films so as to give a thickness of 1 mm by applying heat press. Subsequently, the PET films are allowed to stand at 23°C for 24 hours with the hot-melt coating agent sandwiched between the PET films. Subsequently, the release films are removed, thereby preparing a sample for dynamic viscoelasticity measurement.

Dynamic viscoelasticity (heating process) is measured using the sample as prepared above with a dynamic viscoelasticity measurement device in a rotary shear mode at a frequency of 1 Hz and at a temperature increase rate of 5°C/min within the temperature range of -40°C to 130°C. The temperature (°C) at the point of intersection of the temperature-storage modulus G' curve with the temperature-loss modulus G" curve obtained by measurement within the temperature range of 50°C or more is measured.

The dynamic viscoelasticity measurement device can be any dynamic viscoelasticity measurement device. Examples include an AR-G2 (trade name) rotational rheometer (produced by TA Instruments).

The temperature at the point of intersection can be adjusted, for example, by the following methods. Specifically, the temperature at the point of intersection can be greatly adjusted by using wax that has a high melting point and a sharp molecular weight distribution, or a liquid softener that has a high kinematic viscosity. The temperature at the point of intersection can be slightly adjusted by using wax that has a low melting point and a broad molecular weight distribution, or a liquid softener that has a low kinematic viscosity.

The hot-melt coating agent according to the present invention is intended for a component-mounted electronic circuit board. The electronic component mounted on the component-mounted electronic circuit board can be any component; and is, for example, an IC chip. The hot-melt coating agent according to the present invention is suitable for use in a component-mounted electronic circuit board on which an IC chip is mounted as an electronic component. Generally, when a hot-melt coating agent is applied to a component-mounted electronic circuit board on which an IC chip is mounted as an electronic component, air is pushed out of the gaps between the leads of the IC chip during coating and comes out in the form of bubbles, which is a factor in the decrease in insulation reliability. Due to the configuration described above, the hot-melt coating agent according to the present invention is excellent in bubble-suppression properties during coating, is cured in a short period of time after coating, and is excellent in tack-free properties and bleed-out resistance properties. Thus, the hot-melt coating agent can be used effectively as a hot-melt coating agent for a component-mounted electronic circuit board.

The hot-melt coating agent according to the present invention is solid at room temperature (5 to 35°C). Being solid within this temperature range, the hot-melt coating agent according to the present invention is cured in a short period of time after coating, and is excellent in tack-free properties.

The method for coating a component-mounted electronic circuit board with the hot-melt coating agent according to the present invention can be any method. A known method can be used for coating a component-mounted electronic circuit board with the hot-melt coating agent according to the present invention. Examples of known methods include a method of melting the hot-melt coating agent according to the present invention at a temperature of about 150 to 180°C, discharging the hot-melt coating agent on the surface of a component-mounted electronic circuit board with a dispenser, and forming a coating.

The thickness of a coating is preferably 700 $\mu$m or more, more preferably 1000 $\mu$m or more, and still more preferably 1500 $\mu$m or more. A lower limit of the thickness of the coating film within these ranges further increases the insulation reliability of the coated component-mounted electronic circuit board. The thickness of a coating film is also preferably 4000 $\mu$m or less, more preferably 3000 $\mu$m or less, and still more preferably 2000 $\mu$m or less. An upper limit of the thickness of the coating film within these ranges further increases tack-free properties. The hot-melt coating agent according to the present invention differs from potting compositions in that the thickness of the coating falls within the ranges described above, and in that providing a frame (case) to a component-mounted electronic circuit board in the coating process is unnecessary.

The hot-melt coating agent according to the present invention preferably does not contain a solvent. As it does not contain a solvent, the hot-melt coating agent according to the present invention does not require a drying step after coating, and further shortens the period of time for curing after coating.

Examples

Examples of the present invention are described below. The present invention is not limited to these Examples.

The starting materials used in the Examples and Comparative Examples are as described below.

Thermoplastic Resin (A)

(A1) Styrene-ethylene/butylene-styrene copolymer (SEBS) (SEBS with a triblock structure): G-1650, produced by Kraton Polymers (styrene content: 30 mass%, Mw 80900)

(A2) Styrene-ethylene/butylene-styrene copolymer (SEBS) (SEBS whose main structure is a diblock structure, diblock structure content: about 70%): G-1726, produced by Kraton Polymers (styrene content: 30 mass%, Mw 31300)

(A3) Styrene-butadiene-styrene copolymer (SBS): Asaprene T-438, produced by Asahi Kasei Corporation (styrene content: 30 mass%, Mw 57200)

(A4) Olefin block copolymer (OBC): Infuse D9807, produced by The Dow Chemical Company

(A5) Styrene-ethylene/butylene-styrene copolymer (SEBS) (SEBS with a triblock structure): N504, produced by Asahi Kasei Corporation (styrene content: 32 mass%, Mw 240000)

Liquid Softener (B)

(B1) Paraffin-based process oil: PS-90, produced by Idemitsu Kosan Co., Ltd., kinematic viscosity 90 mm$^2$/S (40°C)
(B2) Paraffin-based process oil: PS-32, produced by Idemitsu Kosan Co., Ltd., kinematic viscosity 32 mm$^2$/S (40°C)
(B3) Naphthene-based process oil: N-90, produced by Idemitsu Kosan Co., Ltd., kinematic viscosity 90 mm$^2$/S (40°C)

Wax (C)

(C1) Paraffin wax: Paraffin Wax 64-66C, produced by PetroChina Company Limited
(C2) Fischer-Tropsch wax: SX105, produced by Nippon Seiro Co., Ltd.

Tackifier (D)

(D1) Terpene phenol resin: Sylvares 1150, produced by Arizona Chemical (softening point: 150°C)
(D2) Hydrogenated petroleum resin: I-MARV P-145, produced by Idemitsu Kosan Co., Ltd. (softening point: 145°C)

Solid Softener (E)

(E1) 1,4-cyclohexane dimethanol dibenzoate: Benzoflex 352, produced by Eastman Chemical Company

Antioxidant (F)

(F1) Phenol-based antioxidant: Evernox 10

Examples and Comparative Examples

The starting materials described above in the formulations illustrated in Table 1 were placed in a stirring kneader equipped with a heating device. The mixture was kneaded with heating at 150°C for 90 minutes and then cooled until the mixture became solid, thereby producing a hot-melt coating agent.
The properties of the obtained hot-melt coating agents were evaluated under the following measurement conditions.

Melt Viscosity

The hot-melt adhesives were each heated and melted, and the viscosity of the melted hot-melt adhesives was measured at 160°C and 180°C with a Brookfield RVT viscometer (spindle No. 27). The viscosity at 160°C and the viscosity at 180°C were respectively determined to be $\eta1$ and $\eta2$. On the basis of the measurement results, the ratio of the viscosity at 160°C ($\eta1$) to the viscosity at 180°C ($\eta2$) ($\eta1/\eta2$) was calculated.

Dynamic Viscoelasticity

Samples for measuring dynamic viscoelasticity were prepared in accordance with the following procedure. Specifically, a hot-melt coating agent was melted by heating at 180°C, and dropped on a release-treated PET film. Subsequently, another release-treated PET film was prepared and placed on the hot-melt coating agent such that the release-treated surface of the film came into contact with the hot-melt coating agent; the PET films were then pressed such that the hot-melt coating agent had a thickness of 1 mm by applying heat press. Subsequently, the PET films were allowed to stand at 23°C for 24 hours with the hot-melt coating agent sandwiched between the PET films. Subsequently, the release films were removed, thereby preparing a sample for dynamic viscoelasticity measurement.
The dynamic viscoelasticity (heating process) was measured using the samples as prepared above with a dynamic viscoelasticity measurement device in a rotary shear mode at a frequency of 1 Hz and at a temperature increase rate of 5°C/min within the temperature range of -40°C to 130°C. The temperature (°C) at the point of intersection of the temperature-storage modulus G' curve with the temperature-loss modulus G" curve obtained by measurement within the temperature range of 50°C or more was measured.

Bubble-Suppression Properties

A dispenser (Melter (Crystal Blue), produced by Nordson Corporation, applicator (MiniBlue II), 3-axis robot (w/4XP robot)) was prepared. The dispenser was programmed such that a hot-melt coating agent was applied on the entire surface of a component-mounted electronic circuit board on which an IC chip was mounted. Subsequently, a hot-melt coating agent was applied to the entire surface of the component-mounted circuit board by using the dispenser with a nozzle diameter of 1.3 mm at a coating temperature of 160°C and at a coating speed of 40 mm/S under a coating pressure of 21 bar such that the hot-melt coating agent had a film thickness of 2000 $\mu$m. The component-mounted electronic circuit board used in this evaluation had the following IC chip mounted. Whether bubbles formed on the leads of the IC chip was observed.

IC chip

Type: QFP
Number of Pins: 64, Pin Pitch: 0.5 mm,
Body Size: 10 mm $\times$ 10 mm, Height: 1.2 mm

An evaluation was performed in accordance with the following evaluation criteria. A rating of C or higher is evaluated as being usable without problems in practice.

A: No bubbles were observed.
B: A slight amount of bubbles was observed; however, the bubbles were fine bubbles, and did not straddle the gap between the leads.
C: Bubbles were observed; however, the bubbles did not straddle the gap between the leads, and did not affect the insulation properties.
D: Bubbles were observed, and straddled the gap between the leads.

Tack-Free Properties

A hot-melt coating agent was applied to the entire surface of a component-mounted circuit board by the same method as in the measurement method for bubble-suppression properties described above. After 30 minutes, a finger was pressed against the surface of the applied hot-melt coating agent, and an evaluation was performed in accordance with following evaluation criteria. A rating of C or higher is evaluated as being usable without problems in practice.

B: The hot-melt coating agent was not sticky at all.
C: The hot-melt coating agent was somewhat sticky, but did not stick to the finger.
D: The hot-melt coating agent was sticky, and stuck to the finger.

High-Temperature Flow Resistance

A hot-melt coating agent melted by heating to 180°C was dropped on a steel plate (70 cm $\times$ 150 cm). Subsequently, a peel-treated PET film was placed on the hot-melt coating agent such that the peel-treated surface of the film came into contact with the hot-melt coating agent, followed by pressing the PET film so as to give a thickness of 2 mm by applying heat press. The hot-melt coating agent was then cooled to room temperature, and a straight-line cut was made in the central part of the hot-melt coating agent to divide the applied agent into two parts. One half of the hot-melt coating agent ranging from the middle part where a cut was made to the end plane was removed, thereby preparing a sample. The sample was placed vertically in an oven heated to 80°C, and measured after 24 hours for how much the hot-melt coating agent ran down from the cut. An evaluation was performed in accordance with the following criteria. A rating of C or higher is evaluated as being usable without problems in practice.

A: The hot-melt coating agent did not run down at all.
B: The hot-melt coating agent ran down in an amount of less than 1 mm from the cut.
C: The hot-melt coating agent ran down in an amount of 1 mm to 2 mm from the cut.
D: The hot-melt coating agent ran down in an amount of more than 2 mm from the cut.

Bleed-Out Resistance Properties

A hot-melt coating agent was applied at a temperature of 160°C to a release-treated PET film with the same dispenser as that used in the measurement method for bubble-suppression properties described above, such that the coating film had a thickness of 2 mm and an area of 5 cm × 5 cm in a square shape; thereby forming a coating film. Subsequently, the coating film was removed from the PET film and placed on a piece of high-quality paper, followed by curing at a temperature of 23° for 3 hours. The cured coating film was observed visually and evaluated in accordance with the following evaluation criteria. A rating of C or higher is evaluated as being usable without problems in practice.

A: No bleeding was observed due to bleed-out of the liquid softener.
B: Slight bleeding was observed due to bleed-out of the liquid softener.
C: Bleed-out of the liquid softener was observed to the extent in which there were no problems.
D: Bleed-out of the liquid softener was observed beyond the shape of the coating film, even on the high-quality paper.

Table 1 illustrates the results. Table 1 does not indicate the evaluation results of Comparative Example 1 because the thermoplastic resin (A1) did not melt in Comparative Example 1, and an evaluation thereof was not made.

EP 3 860 318 A1

Table 1

| (Parts by Mass) | | Example 1 | Example 2 | Example 3 | Example 4 | Example 5 | Example 6 | Example 7 | Example 8 | Example 9 | Example 10 | Example 11 | Example 12 | Example 13 | Example 14 | Example 15 | Comparative Example 1 | Comparative Example 2 | Comparative Example 3 |
|---|---|---|---|---|---|---|---|---|---|---|---|---|---|---|---|---|---|---|---|
| Thermoplastic Resin (A) | (A1) SEBS | 100 | 100 | 100 | 100 | 100 | 100 | 100 | 100 | 100 | 100 | | | | 100 | 100 | 100 | | |
| | (A2) SEBS | | | | | | | | | | | 100 | | | | | | 100 | |
| | (A3) SBS | | | | | | | | | | | | 100 | | | | | | |
| | (A4) OBC | | | | | | | | | | | | | 100 | | | | | |
| | (A5) SEBS | | | | | | | | | | | | | | | | | | 100 |
| Liquid Softener (B) | (B1) Paraffin-Based Process Oil | 298 | 420 | 563 | | | 250 | 170 | 122 | 122 | 122 | | 298 | 198 | 206 | 178 | | | |
| | (B2) Paraffin-Based Process Oil | | | | 298 | | | | | | | 298 | | | | | | 95 | 1890 |
| | (B3) Naphthene-Based Process Oil | | | | | 298 | | | | | | | | | | | | | |
| Wax (C) | (C1) Paraffin Wax | | | | | | 48 | | 48 | | | | | | | | | | |
| | (C2) Fischer-Tropsch Wax | | | | | | | | | 48 | 48 | | | | 67 | 67 | | | |

(continued)

| (Parts by Mass) | | Example 1 | Example 2 | Example 3 | Example 4 | Example 5 | Example 6 | Example 7 | Example 8 | Example 9 | Example 10 | Example 11 | Example 12 | Example 13 | Example 14 | Example 15 | Comparative Example 1 | Comparative Example 2 | Comparative Example 3 |
|---|---|---|---|---|---|---|---|---|---|---|---|---|---|---|---|---|---|---|---|
| Tackifier (D) | (D1) Terpene Phenol Resin | | | | | | | 128 | 128 | 128 | | | | | 144 | 144 | | | |
| | (D2) Hydrogenated Petroleum Resin | | | | | | | | | | 128 | | | | | | | | |
| Solid Softener (E) | (E1) | | | | | | | | | | | | | | 28 | 56 | | | |
| Antioxidant (F) | (F1) Phenol-Based Antioxidant | 2 | 2 | 2 | 2 | 2 | 2 | 2 | 2 | 2 | 2 | 2 | 2 | 2 | 2 | 2 | 2 | 2 | 2 |
| Melt Viscosity (mPa·s) | 160°C ($\eta_1$) | 9800 | 4450 | 540 | 4500 | 9000 | 6650 | 10000 | 12000 | 14000 | 12500 | 340 | 1700 | 15900 | 3250 | 2850 | Unmeasurable | 12100 | 103750 |
| | 180°C ($\eta_2$) | 2180 | 1100 | 135 | 1050 | 2100 | 2000 | 4350 | 4650 | 5700 | 5100 | 123 | 650 | 9800 | 1025 | 900 | Unmeasurable | 1570 | 12950 |
| Melt Viscosity Ratio ($\eta_1/\eta_2$) | | 4.5 | 4.2 | 4.0 | 4.3 | 4.3 | 3.3 | 2.3 | 2.6 | 2.5 | 2.5 | 2.8 | 2.5 | 1.6 | 3.2 | 3.2 | Unmeasurable | 7.7 | 8.0 |
| Point of Intersection of Storage Modulus G' with Loss Modulus G" (°C) | | 100 | 95 | 90 | 90 | 97 | 95 | 100 | 95 | 100 | 98 | 87 | 100 | 90 | 109 | 105 | - | 105 | 135 |
| Bubble-Suppression Properties | | B | B | C | B | B | A | B | A | A | A | C | B | B | A | A | Unevaluable | D | D |
| Tack-Free Properties | | B | B | C | B | B | B | B | B | C | B | C | B | B | B | B | Unevaluable | B | D |

15

(continued)

| (Parts by Mass) | Example 1 | Example 2 | Example 3 | Example 4 | Example 5 | Example 6 | Example 7 | Example 8 | Example 9 | Example 10 | Example 11 | Example 12 | Example 13 | Example 14 | Example 15 | Comparative Example 1 | Comparative Example 2 | Comparative Example 3 |
|---|---|---|---|---|---|---|---|---|---|---|---|---|---|---|---|---|---|---|
| High-Temperature Flow Resistance | A | B | C | B | A | B | A | B | A | A | C | B | B | A | B | Unevaluable | A | A |
| Bleed-Out Resistance Properties of Liquid Softener | A | A | C | A | A | A | A | A | A | A | C | A | B | B | A | Unevaluable | A | B |

**Claims**

1. A hot-melt coating agent for a component-mounted electronic circuit board comprising
a thermoplastic resin (A), and
a liquid softener (B),
the hot-melt coating agent having a melt viscosity at 160°C ($\eta1$) of 20000 mPa·s or less and a melt viscosity at 180°C ($\eta2$) of 10000 mPa·s or less, wherein the ratio of the melt viscosity at 160°C ($\eta1$) to the melt viscosity at 180°C ($\eta2$), which is $\eta1/\eta2$, is 1.0 to 5.0.

2. The hot-melt coating agent for a component-mounted electronic circuit board according to claim 1, wherein within the temperature range of 50°C or more in viscoelasticity measurement performed within the temperature range of -40°C to 130°C, the temperature at the point of intersection of a temperature-storage modulus G' curve with a temperature-loss modulus G" curve is 80°C or more.

3. The hot-melt coating agent for a component-mounted electronic circuit board according to claim 1 or 2, wherein the thermoplastic resin (A) contains at least one member selected from the group consisting of olefin-based block copolymers (OBC), styrene-butylene-styrene copolymers (SBS), styrene-isoprene-styrene copolymers (SIS), styrene-ethylene/butylene-styrene copolymers (SEBS), styrene-ethylene/propylene-styrene copolymers (SEPS), and styrene-ethylene/ethylene/propylene-styrene copolymers (SEEPS).

4. The hot-melt coating agent for a component-mounted electronic circuit board according to any one of claims 1 to 3, wherein the liquid softener (B) is at least one member selected from the group consisting of paraffin-based process oils, naphthene-based process oils, and synthetic hydrocarbon-based oils.

5. The hot-melt coating agent for a component-mounted electronic circuit board according to any one of claims 1 to 4, wherein the content of the liquid softener (B) is 100 to 500 parts by mass per 100 parts by mass of the thermoplastic resin (A).

6. The hot-melt coating agent for a component-mounted electronic circuit board according to any one of claims 1 to 5, further comprising at least one wax (C) selected from the group consisting of paraffin-based wax, vinyl acetate-based wax, polyethylene-based wax, polypropylene-based wax, and Fischer-Tropsch wax, wherein the content of the wax (C) is 50 parts by mass or less per 100 parts by mass of the thermoplastic resin (A).

7. The hot-melt coating agent for a component-mounted electronic circuit board according to any one of claims 1 to 6, further comprising at least one tackifier (D) selected from the group consisting of naturally occurring tackifiers, petroleum resin-based tackifiers, and hydrogenated products of petroleum resin-based tackifiers, wherein the content of the tackifier (D) is 150 parts by mass or less per 100 parts by mass of the thermoplastic resin (A).

8. The hot-melt coating agent for a component-mounted electronic circuit board according to any one of claims 1 to 7, further comprising at least one solid softener (E) selected from the group consisting of triethylene glycol tribenzoate, trimethylol ethane tribenzoate, glycerol tribenzoate, sucrose benzoate, pentaerythritol tetrabenzoate, 2,2-dimethyl-1,3-propanediol dibenzoate, triethylene glycol dibenzoate, glycerol tribenzoate, 2-hydroxymethyl-2-methyl-1,3-propanediol tribenzoate pentaerythritol tetrabenzoate, and neopentylglycol dibenzoate, wherein the content of the solid softener (E) is 60 parts by mass or less per 100 parts by mass of the thermoplastic resin (A).

**INTERNATIONAL SEARCH REPORT**

| International application No. |
| --- |
| PCT/JP2019/036937 |

| | |
| --- | --- |
| A. CLASSIFICATION OF SUBJECT MATTER | |
| Int.Cl. H05K3/28(2006.01)i, C09D7/65(2018.01)i, C09D153/00(2006.01)i, C09D191/00(2006.01)i, C09D191/06(2006.01)i, C09D201/00(2006.01)i | |
| According to International Patent Classification (IPC) or to both national classification and IPC | |

| | |
| --- | --- |
| B. FIELDS SEARCHED | |
| Minimum documentation searched (classification system followed by classification symbols) | |
| Int.Cl. H05K3/28, C09D7/65, C09D153/00, C09D191/00, C09D191/06, C09D201/00 | |

| | |
| --- | --- |
| Documentation searched other than minimum documentation to the extent that such documents are included in the fields searched | |
| Published examined utility model applications of Japan | 1922–1996 |
| Published unexamined utility model applications of Japan | 1971–2019 |
| Registered utility model specifications of Japan | 1996–2019 |
| Published registered utility model applications of Japan | 1994–2019 |

| |
| --- |
| Electronic data base consulted during the international search (name of data base and, where practicable, search terms used) |

| |
| --- |
| C. DOCUMENTS CONSIDERED TO BE RELEVANT |

| Category* | Citation of document, with indication, where appropriate, of the relevant passages | Relevant to claim No. |
| --- | --- | --- |
| A | JP 10-265719 A (SEKISUI CHEMICAL CO., LTD.) 06 October 1998, entire text, all drawings (Family: none) | 1–8 |
| A | JP 2002-115341 A (AOI CHEMICAL INC.) 19 April 2002, entire text, all drawings (Family: none) | 1–8 |
| A | JP 2000-219587 A (NIPPON KOKI CO., LTD.) 08 August 2000, entire text, all drawings (Family: none) | 1–8 |

☒ Further documents are listed in the continuation of Box C. ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 18 November 2019 (18.11.2019) | 26 November 2019 (26.11.2019) |

| Name and mailing address of the ISA/ Japan Patent Office 3-4-3, Kasumigaseki, Chiyoda-ku, Tokyo 100-8915, Japan | Authorized officer Telephone No. |
| --- | --- |

Form PCT/ISA/210 (second sheet) (January 2015)

## INTERNATIONAL SEARCH REPORT

| International application No. |
|---|
| PCT/JP2019/036937 |

C (Continuation). DOCUMENTS CONSIDERED TO BE RELEVANT

| Category* | Citation of document, with indication, where appropriate, of the relevant passages | Relevant to claim No. |
|---|---|---|
| P, A | JP 2019-119882 A (SEKISUI FULLER COMPANY, LTD.) 22 July 2019, entire text, all drawings (Family: none) | 1-8 |

Form PCT/ISA/210 (continuation of second sheet) (January 2015)

**EP 3 860 318 A1**

## REFERENCES CITED IN THE DESCRIPTION

### Patent documents cited in the description

- JP 2005194392 A